(19) Europäisches Patentamt
European Patent Office
Office européen des brevets

(11) **EP 3 754 837 B1**

(12) **EUROPÄISCHE PATENTSCHRIFT**

(45) Veröffentlichungstag und Bekanntmachung des Hinweises auf die Patenterteilung:
**17.01.2024 Patentblatt 2024/03**

(21) Anmeldenummer: **19180500.1**

(22) Anmeldetag: **17.06.2019**

(51) Internationale Patentklassifikation (IPC):
**H02P 6/34** *(2016.01)*    **H02P 6/08** *(2016.01)*
**H02P 23/14** *(2006.01)*

(52) Gemeinsame Patentklassifikation (CPC):
**H02P 6/34; H02P 6/08; H02P 23/14**

(54) **VERFAHREN ZUR ÜBERWACHUNG EINER MASCHINE**

METHOD FOR MONITORING A MACHINE

PROCÉDÉ DE SURVEILLANCE D'UNE MACHINE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**23.12.2020 Patentblatt 2020/52**

(73) Patentinhaber: **Schneider Electric Industries SAS**
**92500 Rueil Malmaison (FR)**

(72) Erfinder:
• **Rieger, Michael**
**97855 Lengfurt (DE)**
• **Heid, Jürgen**
**97237 Altertheim (DE)**

(74) Vertreter: **Manitz Finsterwald**
**Patent- und Rechtsanwaltspartnerschaft mbB**
**Martin-Greif-Strasse 1**
**80336 München (DE)**

(56) Entgegenhaltungen:
**EP-A1- 3 258 331       DE-A1-102011 121 839**
**DE-A1-102015 200 609**

**Beschreibung**

Die vorliegende Erfindung betrifft ein Verfahren zur Überwachung einer Maschine, bei welchem eine Mechanik durch einen Motor bewegt wird, wobei die Mechanik mehr als zwei miteinander gekoppelte Komponenten umfasst, wobei eine der Komponenten den Motor umfasst und wobei zumindest zwei der Komponenten sich unterschiedlich bewegen, wenn der Motor die Mechanik antreibt.

Verfahren zur Überwachung einer Maschine, bei welchen Bewegungsgrößen eines Motors ermittelt werden, sind aus der EP 3 258 331 A1, der DE 10 2015 200 609 A1 und der DE 10 2011 121 839 A1 bekannt. In den genannten Dokumenten werden die Bewegungsgrößen dazu verwendet, jeweils Parameter einer weiteren Komponente zu ermitteln.

Insbesondere bei industriellen Maschinen werden häufig mechanisch miteinander gekoppelte Komponenten verwendet, die von einem Motor angetrieben werden. Beispielsweise kann der Motor eine Antriebswelle antreiben, wobei die Antriebswelle dann dazu dient, verschiedene bewegbare Komponenten der Maschine anzutreiben. Die hierbei entstehende mechanische Struktur kann sehr komplex werden, wodurch für den Motor stark schwankende Drehmomentanforderungen entstehen können. Dies kann beispielsweise darin begründet liegen, dass mittels der Antriebswelle z.B. eine Kurbel angetrieben wird, welche wiederum einen sich hin und her bewegenden Schlitten antreibt. Je nach Position und Geschwindigkeit des Schlittens können dabei unterschiedliche Kräfte, Reibungen und Drehmomente auftreten. Andere mit der Antriebswelle gekoppelte Komponenten können zugleich andere Kräfte und Drehmomente auf den Motor bewirken.

Zusätzlich zu den ohnehin im Betrieb schwankenden Kraft- und Drehmomentanforderungen können durch Verschleiß oder äußere Einwirkungen zusätzliche zeitlich veränderliche Kraft- oder Drehmomentkomponenten auf den Motor einwirken.

Insbesondere bei Mechaniken aus mehreren miteinander gekoppelten Komponenten sind die von der Mechanik erzeugten Kräfte und Drehmomente daher meist nur mit großem Aufwand und nur theoretisch grob bestimmbar.

Die der Erfindung zugrunde liegende Aufgabe ist es, ein Verfahren anzugeben, welches mechanische Parameter, wie Kräfte und Drehmomente der Mechanik, auf einfache Weise bestimmbar macht und somit eine Überwachung einer industriellen Maschine auf Veränderungen sowie eine Verbesserung des Laufverhaltens der Maschine auf einfache Weise ermöglicht..

Diese Aufgabe wird durch ein Verfahren gemäß Anspruch 1 und eine Vorrichtung gemäß Anspruch 15 gelöst.

Gemäß dem erfindungsgemäßen Verfahren wird zumindest eine, alternativ auch nur eine, Bewegungsgröße einer der Komponenten der Mechanik wiederholt ermittelt. Zudem wird zumindest eine, alternativ auch nur eine, dynamische Größe einer der Komponenten der Mechanik wiederholt ermittelt. Anschließend werden mittels eines Modells der Mechanik und insbesondere der ermittelten Bewegungsgröße die Bewegungsgrößen der übrigen Komponenten der Mechanik berechnet. Schließlich werden aus der ermittelten Bewegungsgröße, der ermittelten dynamischen Größe und den berechneten Bewegungsgrößen separate mechanische Parameter für die, bevorzugt für alle, Komponenten der Mechanik bestimmt.

Anders ausgedrückt wird erfindungsgemäß eine Messung oder Beobachtung an einer der Komponenten der Mechanik durchgeführt, während die Mechanik eine Bewegung ausführt, um eine Bewegungsgröße und eine dynamische Größe der Komponente zu ermitteln. Da nunmehr bekannt ist, wie sich die eine Komponente bewegt, kann mittels des Modells der Mechanik berechnet werden, wie sich die übrigen Komponenten der Mechanik bewegen. Dies bedeutet, es können die Bewegungsgrößen der übrigen Komponenten der Mechanik berechnet werden. Nachdem zusätzlich eine dynamische Größe der Komponente der Mechanik bekannt ist, z.B. durch Messung des Drehmoments, welches die Komponente in die Mechanik einbringt, kann auch ein dynamischer Parameter, d.h. ein mechanischer Parameter (z.B. ebenfalls ein Drehmoment oder eine Reibung), für eine weitere Komponente der Mechanik bestimmt werden. Durch die wiederholte Ermittlung der dynamischen Größe können insbesondere eine Vielzahl von zeitlich nacheinander erfassten Messwerten zur Verfügung stehen, aus welchen sich dann für mehrere oder sogar alle Komponenten der Mechanik mechanische Parameter bestimmen lassen. Die Bestimmung der mechanischen Parameter kann insbesondere in einer Steuereinheit der Maschine oder einer externen Steuereinheit erfolgen.

Unter einem mechanischen Parameter ist insbesondere ein Drehmoment, eine Kraft und/oder ein Parameter zur Berechnung eines Drehmoments oder einer Kraft basierend z.B. auf einer Beschleunigung oder Geschwindigkeit zu verstehen, wie später noch genauer ausgeführt wird. Eine Bewegungsgröße hingegen gibt z.B. eine Geschwindigkeit, Beschleunigung oder Position einer Komponente der Mechanik an, wie ebenfalls später detaillierter dargestellt wird.

Die dynamische Größe kann einem der mechanischen Parameter entsprechen, im Gegensatz zum mechanischen Parameter aber gemessen bzw. ermittelt werden.

Insbesondere werden die Bewegungsgröße und die dynamische Größe bei derselben Komponente der Mechanik wiederholt ermittelt. Bevorzugt werden die Bewegungsgröße und die dynamische Größe jeweils zum selben Zeitpunkt ermittelt.

Unter einer Komponente der Mechanik können prinzipiell beliebige Konstruktionen oder Abschnitte der Mechanik, z.B. Abschnitte eines Antriebsstrangs, verstanden werden. Eine Komponente kann beispielsweise der Motor mit einer Antriebswelle sein. Eine weitere Komponente kann ein an der Antriebswelle befestigtes Getriebe, eine Exzenter-Scheibe und dergleichen sein. Weiterhin kann als Komponente der Mechanik z.B. ein über das Getriebe angetriebenes Förderband, eine mittels der Exzenter-Scheibe bewegte Masse und dergleichen sein. Generell kann eine Komponente z.B. als Teil der Maschine angesehen werden, für welchen zumindest ein oder mehrere mechanische Parameter bestimmt werden.

Unter der Ermittlung einer Größe wird insbesondere verstanden, dass die Größe gemessen und/oder aus einem gemessenen Wert berechnet wird. Beispielsweise kann die dynamische Größe das vom Motor an die übrige Mechanik abgegebene Drehmoment sein. Dieses Drehmoment kann entweder direkt gemessen werden oder anhand eines von dem Motor aufgenommenen Stroms (welcher gemessen wird) und/oder einer von dem Motor aufgenommenen gemessenen Leistung berechnet werden.

Der Motor ist dabei als Komponente oder als Teil einer Komponente der Mechanik zu verstehen. Der Motor ist die Komponente, die die Mechanik antreibt. Hierzu kann der Motor insbesondere eine Rotation einer Motorwelle durchführen. Die übrigen Komponenten der Mechanik können beispielsweise lineare und/oder Drehbewegungen ausführen. Hierbei sind beliebige Formen der Bewegung denkbar, beispielsweise Mischungen aus linearen Bewegungen und Drehbewegungen, exzentrische Bewegungen und dergleichen. Anders ausgedrückt führt der Motor eine Eintriebsbewegung aus, welche die übrigen Komponenten jeweils in eine Abtriebsbewegung versetzt. Die Bewegung der Komponenten wird durch die Bewegungsgrößen beschrieben und kann anhand der später genauer erläuterten Übertragungsfunktion aus der Drehbewegung des Motors und/oder der Bewegung der Komponenten berechnet werden.

Die erfindungsgemäß bestimmten mechanischen Parameter sind bevorzugt jeweils genau einer Komponente zugeordnet. Die mechanischen Parameter können für unterschiedliche Zeiten oder unterschiedliche Positionen der jeweiligen Komponente bestimmt werden.

Insbesondere umfasst die Mechanik genau einen Motor.

Unter einer unterschiedlichen Bewegung ist z.B. zu verstehen, dass zwei Komponenten sich nicht parallel und gleichförmig bewegen, sondern z.B. gegenläufige Bewegungen ausführen, sich zu einem Zeitpunkt mit unterschiedlichen Geschwindigkeiten und/oder Beschleunigungen bewegen, sich in unterschiedliche Richtungen bewegen und dergleichen. Unterschiedliche Bewegungen können auch lineare Bewegungen im Vergleich zu Drehbewegungen sein.

Vorteilhafte Weiterbildungen der Erfindung sind der Beschreibung, den Zeichnungen sowie den Unteransprüchen zu entnehmen.

Gemäß einer ersten vorteilhaften Ausführungsform wird eine Vielzahl von Werten der ermittelten Bewegungsgröße und/oder der ermittelten dynamischen Größe herangezogen, um die mechanischen Parameter für die Komponenten der Mechanik zu bestimmen. Die Vielzahl der ermittelten Werte kann Werte für unterschiedliche Zeiten und Bewegungszustände der Maschine umfassen. Zu unterschiedlichen Zeiten und bei unterschiedenen Zuständen können die ermittelten Werte voneinander abweichen, da die Komponenten der Maschine sich beispielsweise vor- und zurückbewegen können, bewegungsabhängige Reibung vorliegen kann, Einflüsse und/oder Rückwirkungen durch von der Maschine bearbeitete Produkte (z.B. unterschiedliche Massen der Produkte) vorliegen können,usw.

Gemäß einer weiteren vorteilhaften Ausführungsform wird das erfindungsgemäße Matrix- Gleichungssystem mit einer Vielzahl von Gleichungen, bevorzugt mit einer Gleichung pro Wert der ermittelten Bewegungsgröße, aufgestellt und gelöst, um die mechanischen Parameter zu bestimmen. Pro Gleichung kann insbesondere jeweils genau eine Unbekannte für jeden zu bestimmenden mechanischen Parameter vorhanden sein.

Gemäß einer weiteren vorteilhaften Ausführungsform umfasst die Bewegungsgröße eine Geschwindigkeit, eine Position, eine Beschleunigung, eine Winkelgeschwindigkeit, eine Winkelposition und/oder eine Winkelbeschleunigung. Die Bewegungsgröße kann also Größen umfassen, die eine translatorische Bewegung oder eine rotatorische Bewegung einer Komponente beschreiben. Allgemein gesprochen beschreibt die Bewegungsgröße zusammen mit ggfs. weiteren Bewegungsgrößen eine Bewegung einer der Komponenten. Insbesondere ist die Bewegungsgröße von außerhalb der Komponente, z.B. optisch und/oder ohne Berührung der Komponente, erfassbar.

Gemäß einer weiteren vorteilhaften Ausführungsform umfasst das Modell der Mechanik zumindest eine Übertragungsfunktion, welche die Bewegung einer ersten Komponente in Abhängigkeit der Bewegung einer zweiten Komponente, welche mit der ersten Komponente gekoppelt ist, beschreibt. Aufgrund der Übertragungsfunktion ist es mit dem Modell beispielsweise möglich, aus der bekannten (gemessenen) Rotation der Antriebsachse des Motors auf die Bewegung einer direkt mit dem Motor gekoppelten Komponente rückzuschließen und die Bewegung der mit dem Motor gekoppelten Komponente zu berechnen. Beispielsweise kann der Motor über eine Kurbelstange einen Schlitten vor und zurück bewegen. Hierfür kann das Modell eine entsprechende Übertragungsfunktion umfassen, sodass aus der Winkelposition, der Winkelgeschwindigkeit und der Winkelbeschleunigung des Motors (bzw. der Motorwelle) die momentane Position, Geschwindigkeit und Beschleunigung des Schlittens berechnet werden können. Insbesondere kann der Motor als Sensor, bevorzugt als einziger Sensor, verwendet werden, indem der vom Motor aufgenommene Strom und die Drehposition des Motors gemessen werden. Als Sensor oder einziger Sensor kann auch ein Servogerät, d.h. der Motor mit seiner Steuerung und gegebenenfalls einem Drehgeber, verwendet werden.

Überdies kann das Modell auch weitere Übertragungsfunktionen umfassen, welche die Bewegung von weiteren Komponenten angeben. Insbesondere kann eine Kette von Übertragungsfunktionen zur Beschreibung der Bewegung sämtlicher Komponenten der Mechanik von dem Modell umfasst sein. Beispielsweise kann an dem vorgenannten Schlitten eine Feder befestigt sein, welche wiederum einen Arm bewegt. Die Bewegung des Arms kann dann durch eine weitere Übertragungsfunktion basierend auf der Bewegung des Schlittens berechnet werden.

Weiterhin kann das Modell Randbedingungen für die Bewegungen der Komponenten umfassen, beispielsweise mechanische Begrenzungen.

Gemäß einer weiteren vorteilhaften Ausführungsform werden die Bewegungsgrößen jeweils mit einer Ableitung der Übertragungsfunktion, welche die Bewegung der jeweiligen Komponente beschreibt, multipliziert. Die Ableitung wird insbesondere durch einen Bruch definiert, welcher im Zähler die Änderung der Bewegung der jeweiligen beschriebenen Komponente umfasst, wohingegen im Nenner die Änderung der die beschriebene Komponente antreibenden Komponente umfasst ($dx_{out}/dx_{in}$). Durch die Ableitung wird es vorteilhafterweise ermöglicht, veränderliche Vorgänge in der Maschine mit zu erfassen. Die Ableitung vermittelt insbesondere auch die Umrechnung von Abtriebsmoment zu Eintriebsmoment bzw. von Abtriebskraft zu Eintriebskraft oder von Abtriebskraft zu Eintriebsmoment bzw. von Abtriebsmoment zu Eintriebskraft einer der Komponenten.

Gemäß einer weiteren vorteilhaften Ausführungsform umfassen die mechanischen Parameter ein Drehmoment und/oder eine Kraft, insbesondere ein konstantes Drehmoment, ein Trägheitsmoment, eine viskose Reibung, eine statische Reibung und/oder eine konstante Kraft. Das konstante Drehmoment kann beispielsweise durch Reibung verursacht werden. Alternativ oder zusätzlich umfassen die mechanischen Parameter eine Konstante zur Berechnung eines Drehmoments oder einer Kraft basierend z.B. auf einer Beschleunigung oder Geschwindigkeit.

Unter den mechanischen Parametern sind insbesondere Werte zu verstehen, die Komponenten der Mechanik beschreiben und welche insbesondere dynamische Vorgänge beschreiben, d.h. Werte die abhängig von der momentanen Geschwindigkeit, der momentanen Position und/oder der momentanen Beschleunigung einer der Komponenten sind.

Insbesondere können die mechanischen Parameter umfassen:

- einen Parameter für eine geschwindigkeitsabhängige Kraft *($k_{Fvel}$)*, bevorzugt mit der Einheit [N/(1/s)];
- einen Parameter für eine statische Kraft ($k_{Fstat}$), bevorzugt mit der Einheit [N];
- einen Parameter für eine konstante Kraft ($k_{Fconst}$), bevorzugt mit der Einheit [N];
- eine Masse *m* (Einheit [kg]);
- ein Trägheitsmoment J (Einheit [kg*m$^2$]);
- einen Parameter für ein drehgeschwindigkeitsabhängiges Drehmoment ($k_{Mvel}$), bevorzugt mit der Einheit [Nm/(rad/s)];
- einen Parameter für ein statisches Drehmoment ($k_{Mstat}$), bevorzugt mit der Einheit [Nm]; und/oder
- einen Parameter für ein konstantes Drehmoment ($k_{Mconst}$), bevorzugt mit der Einheit [Nm].

Die statische Kraft und/oder das statische Drehmoment, welche durch die Parameter $k_{Fstat}$ bzw. $k_{Mstat}$ beschrieben werden, wirken bevorzugt nur bei einer Geschwindigkeit oder Winkelgeschwindigkeit von ungleich Null und wirken insbesondere der Bewegungsrichtung entgegen. Die konstante Kraft und/oder das konstante Drehmoment, welche durch die Parameter $k_{Fconst}$ bzw. $k_{Mconst}$ beschrieben werden, wirken bevorzugt immer.

Gemäß einer weiteren vorteilhaften Ausführungsform wird das hierin beschriebene Verfahren mehrmals, insbesondere zwei Mal, separat ausgeführt, um mechanische Parameter für unterschiedliche Bewegungsrichtungen einer (derselben) Komponente zu bestimmen. Eine separate Ausführung des Verfahrens kann auch für jede Bewegungsrichtung jeder Komponente vorgenommen werden. Beispielsweise kann das Verfahren einmal ausgeführt werden, während eine Komponente sich in eine erste Richtung bewegt. Ein zweites Mal kann das Verfahren ausgeführt werden, wenn die Komponente sich dann in eine zweite Richtung bewegt, welche der ersten Richtung entgegengesetzt ist. Die Bewegung kann dabei sowohl translatorisch als auch rotatorisch sein.

Durch die mehrmalige Ausführung des Verfahrens lassen sich insbesondere die oben genannten Parameter zur Beschreibung der statischen Kraft und/oder des statischen Drehmoments bestimmen. Ohne die mehrmalige Ausführung können insbesondere nur die Parameter zur konstanten Kraft und zum konstanten Drehmoment bestimmt werden.

Zur Bestimmung der Parameter $k_{Fstat}$ und $k_{Mstat}$ wird bei der jeweiligen Ausführung des Verfahrens jeweils der Parameter $k_{Fconst}$ bestimmt. Aufgrund des Umstands, dass die statische Kraft und das statische Drehmoment jeweils der Bewegung entgegenwirken und die konstante Kraft und das konstante Drehmoment immer in dieselbe Richtung wirken ergeben sich die Gleichungen

$$k_{Mconst\_Richtung\ 1} = k_{Mconst} + k_{Mstat}$$

$$k_{Mconst\_Richtung\,2} = k_{Mconst} - k_{Mstat}$$

für rotatorische Bewegungen. Für translatorische Bewegungen hingegen ergibt sich:

$$k_{Fconst\_Richtung\,1} = k_{Fconst} + k_{Fstat}$$

$$k_{Fconst\_Richtung\,2} = k_{Fconst} - k_{Fstat}$$

Diese Gleichungen können aufgelöst werden zu

$$k_{Mconst} = (k_{Mconst\_Richtung\,1} + k_{Mconst\_Richtung\,2}) / 2$$

$$k_{Mstat} = (k_{Mconst\_Richtung\,1} - k_{Mconst\_Richtung\,2}) / 2$$

und

$$k_{Fconst} = (k_{Fconst\_Richtung\,1} + k_{Fconst\_Richtung\,2}) / 2$$

$$k_{Fstat} = (k_{Fconst\_Richtung\,1} - k_{Fconst\_Richtung\,2}) / 2.$$

Auf diese Weise können also richtungsabhängige Kräfte und Drehmomente bestimmt werden, welche nur bei Bewegung auftreten.

Bei der Aufstellung des Gleichungssystems wird bevorzugt für jeden mechanischen Parameter ein Term in jede Gleichung des Gleichungssystems eingefügt, welcher den mechanischen Parameter mit einer gemessenen, berechneten oder anderweitig ermittelten Größe (d.h. einer Bewegungsgröße) und/oder mit der Ableitung der jeweiligen Übertragungsfunktion multipliziert. Der Term wird dabei insbesondere so gewählt, dass in jedem Term jeweils ein Drehmoment berechnet wird. Anschließend können alle Terme addiert werden, wodurch sich insbesondere ein Gesamtdrehmoment ergibt, welches dem vom Motor aufzubringenden und an die Mechanik abzugebenden Drehmoment entspricht.

In diesem Zusammenhang ist zu erwähnen, dass der Motor zu jedem Zeitpunkt bevorzugt das Gesamt-Drehmoment bereitstellt, das benötigt wird, um alle Komponenten zu bewegen. Aufgrund der Energieerhaltung kann somit durch das vom Motor abgegebene Drehmoment und der Messung der Drehbewegung desselben auf die mechanischen Parameter der übrigen Komponenten geschlossen werden. Aufgrund der Energieerhaltung ist die vom Motor mittels rotatorischer Bewegung eingebrachte Energie gleich der von den übrigen Komponenten bei deren translatorischen und/oder rotatorischen Bewegungen benötigten Energie. Aufgrund der Energieerhaltung ist es möglich mittels der oben erläuterten Ableitung zwischen einer Abtriebskraft (bei translatorischen Bewegungen) und einem dazu notwendigen Eintriebsdrehmoment (bei rotatorischen Bewegungen) umzurechnen (oder umgekehrt). Bei rotatorischem Eintrieb und rotatorischem Abtrieb vermittelt die Ableitung zwischen dem Abtriebsdrehmoment und dem dazu notwendigen Eintriebsdrehmoment. Die Ableitung wirkt als positionsabhängiger "Getriebefaktor".

Umfasst die Mechanik nun beispielhaft drei Komponenten (K1, K2 und K3), wobei der Motor selbst eine Drehbewegung (mit der Funktion $\varphi_{K1}$) z.B. einer Kurbel ausführt und dabei eine sich translatorisch bewegende zweite Komponente und eine eine Drehbewegung ausführende dritte Komponente antreibt, so kann in einer jeweiligen Gleichung des Gleichungssystems das vom Motor abgegebene Drehmoment $M$ gleichgesetzt werden mit neun Termen:

$$M = (\alpha_{K1} * J_{K1} + \omega_{K1} * k_{Mvel,\,K1} + k_{Mstat,\,K1}) + (acc_{K2} * \frac{dx_{K2}}{d\varphi_{K1}} * m_{K2} + vel_{K2} * \frac{dx_{K2}}{d\varphi_{K1}} * k_{Fvel,}$$

$$_{K2} + \frac{dx_{K2}}{d\varphi_{K1}} * k_{Fstat,\,K2}) + (\alpha_{K3} * \frac{d\varphi_{K3}}{d\varphi_{K1}} * J_{K3} + \omega_{K3} * \frac{d\varphi_{K3}}{d\varphi_{K1}} * k_{Mvel,\,K3} + \frac{d\varphi_{K3}}{d\varphi_{K1}} * k_{Mstat,\,K3})$$

Die Bewegungen der zweiten und dritten Komponente werden durch Übertragungsfunktionen beschrieben, die im obigen Beispiel $x_{K2}$ bzw. $\varphi_{K3}$ genannt sind. Ein "x" zeigt dabei eine translatorische Bewegung, ein "$\varphi$" eine

rotatorische Bewegung an. Da sowohl die zweite als auch die dritte Komponente von der ersten Komponente (d.h. dem Motor) angetrieben werden, erfolgt die Ableitung in diesem Beispiel immer nach der Funktion $\varphi_{K1}$. Die Ableitung der Übertragungsfunktion für die erste Komponente ist nicht explizit dargestellt. Da die erste Komponente "sich selbst" antreibt ist die Übertragungsfunktion hier eine Proportionalität, deren Ableitung "1" ergibt.

Die Werte für M, $\alpha$, $\omega$, *acc* und *vel* sind dabei durch Messung oder Berechnung bekannt und werden in eine Gleichung für denselben Zeitpunkt eingetragen. Durch die vielfache Messung bzw. Berechnung der Werte können jeweils neue Gleichungen für andere Zeitpunkte aufgestellt werden, wodurch sich ein Gleichungssystem ergibt, welches zumindest gleich viele oder mehr Gleichungen als Unbekannte enthält.

Allgemein kann das Gleichungssystem für n Komponenten als Matrix-Gleichungssystem geschrieben werden, welches dann die folgende Form aufweist:

$$[BG_{K1} \mid BG_{K2} \mid BG_{K3} \mid \ldots \mid BG_{Kn}] * (MP) = (M)$$

$BG_{Ki}$ ist dabei eine Matrix der Bewegungsgrößen. MP ist ein Vektor mit den zu ermittelnden mechanischen Parametern. M ist ein Vektor mit Drehmomenten. Diese Drehmomente entsprechen bevorzugt dem jeweils vom Motor zu einem Zeitpunkt abgegebenen Drehmoment.

Zur eindeutigen Lösung des Matrix-Gleichungssystems kann auf beiden Seiten des Gleichungssystems eine Multiplikation mit der Transponierten der Matrix aller Bewegungsgrößen durchgeführt werden. Hierbei entsteht ein neues gleichwertiges Matrix-Gleichungssystem, allerdings mit einer quadratischen Matrix, was nun eine eindeutige Lösung des Gleichungssystems ermöglicht, da die Anzahl der Zeilen und Spalten der Matrix gleich der Anzahl der gesuchten mechanischen Parameter ist. Die gesuchten mechanischen Parameter können dann berechnet werden, wobei die ermittelten mechanischen Parameter insbesondere auf einer Hyperebene in einem Raum mit der Dimension "Anzahl der gesuchten mechanischen Parameter" liegen. Die gesuchten mechanischen Parameter und damit die Hyperebene können bevorzugt so bestimmt werden, dass die Summe der Abweichungsquadrate minimiert wird ("least-square-fit").

Es kann also die folgende Umformung vorgenommen werden:

$$\mathbf{A} * (MP) = (M)$$

zu

$$(\mathbf{A^T} * \mathbf{A}) * (MP) = \mathbf{A^T} * (M)$$

Dabei ist $\mathbf{A}$ eine Matrix mit sämtlichen Matrizen $BG_{Ki}$ und $\mathbf{A^T}$ die Transponierte der Matrix A.

Im Folgenden wird nochmals das obige Beispiel weiter erläutert, bei welchem der Motor eine sich translatorisch bewegende zweite Komponente und eine eine Drehbewegung ausführende dritte Komponente antreibt. Bei Messungen zu unterschiedlichen Zeitpunkten (t1, t2, t3, ..., tn) können jeweils neue Gleichungen aufgestellt werden, wobei das so entstehende Gleichungssystem nachfolgend und erfindungsgemäß als Matrix-Gleichungssystem dargestellt ist.

$$\begin{pmatrix} \alpha_{K1,t1} & \omega_{K1,t1} & 1 & acc_{K2,t1} * \frac{dx_{K2,t1}}{d\varphi_{K1,t1}} & vel_{K2,t1} * \frac{dx_{K2,t1}}{d\varphi_{K1,t1}} & \frac{dx_{K2,t1}}{d\varphi_{K1,t1}} & \alpha_{K3,t1} * \frac{d\varphi_{K3,t1}}{d\varphi_{K1,t1}} & \omega_{K3,t1} * \frac{d\varphi_{K3,t1}}{d\varphi_{K1,t1}} & \frac{d\varphi_{K3,t1}}{d\varphi_{K1,t1}} \\ \alpha_{K1,t2} & \omega_{K1,t2} & 1 & acc_{K2,t2} * \frac{dx_{K2,t2}}{d\varphi_{K1,t2}} & vel_{K2,t2} * \frac{dx_{K2,t2}}{d\varphi_{K1,t2}} & \frac{dx_{K2,t2}}{d\varphi_{K1,t2}} & \alpha_{K3,t2} * \frac{d\varphi_{K3,t2}}{d\varphi_{K1,t2}} & \omega_{K3,t2} * \frac{d\varphi_{K3,t2}}{d\varphi_{K1,t2}} & \frac{d\varphi_{K3,t2}}{d\varphi_{K1,t2}} \\ \ldots & \ldots & \ldots & \ldots & \ldots & \ldots & \ldots & \ldots & \ldots \\ \alpha_{K1,tn} & \omega_{K1,tn} & 1 & acc_{K2,tn} * \frac{dx_{K2,tn}}{d\varphi_{K1,tn}} & vel_{K2,tn} * \frac{dx_{K2,tn}}{d\varphi_{K1,tn}} & \frac{dx_{K2,tn}}{d\varphi_{K1,tn}} & \alpha_{K3,tn} * \frac{d\varphi_{K3,tn}}{d\varphi_{K1,tn}} & \omega_{K3,tn} * \frac{d\varphi_{K3,tn}}{d\varphi_{K1,tn}} & \frac{d\varphi_{K3,tn}}{d\varphi_{K1,tn}} \end{pmatrix}$$

$$* \begin{pmatrix} J_{K1} \\ k_{Mvel,K1} \\ k_{Mstat,K1} \\ m_{K2} \\ k_{Fvel,K2} \\ k_{Fstat,K2} \\ J_{K3} \\ k_{Mvel,K3} \\ k_{Mstat,K3} \end{pmatrix} = \begin{pmatrix} M_{t1} \\ M_{t2} \\ \ldots \\ M_{tn} \end{pmatrix}$$

Für jede Zeile ergibt sich aus dem Matrix-Gleichungssystem eine Gleichung für einen jeweiligen Zeitpunkt.

Beispielsweise wird für die zweite Komponente die Geschwindigkeit acc (in [m/s]) mit dem Parameter $k_{Fvel}$ (in [N/(1/s)]) und mit der Ableitung der Übertragungsfunktion ( $\frac{dx_{K2}}{d\varphi_{K1}}$ , Einheit [m]) multipliziert, um ein Drehmoment ([kg*m²/s²] oder [Nm]) in dem Term zu erhalten.

Insbesondere können für eine Komponente der Mechanik drei Terme in die Gleichungen des Gleichungssystems eingefügt werden. Hierbei kann bevorzugt zwischen einer translatorischen Bewegung und einer Drehbewegung unterschieden werden. Bei einer translatorischen Bewegung kann der erste Term die Multiplikation der Beschleunigung *acc* mit der Ableitung der Übertragungsfunktion (z.B. dx/dφ) der Komponente und weiterer Multiplikation mit der Masse *m* der Komponente sein. Der zweite Term kann die Multiplikation der Geschwindigkeit *vel* der Komponente mit der Ableitung der Übertragungsfunktion und dem Parameter $k_{Fvel}$ sein, d.h. *vel* * $k_{Fvel}$. Der dritte Term kann lediglich die Multiplikation der Ableitung der Übertragungsfunktion mit $k_{Fstat}$ oder $k_{Fconst}$ umfassen.

Für eine Drehbewegung kann der erste Term die Multiplikation der Winkelbeschleunigung α der Komponente mit der Ableitung der Übertragungsfunktion und dem Trägheitsmoment *J* der Komponente sein. Der zweite Term kann die Multiplikation der Winkelgeschwindigkeit ω der Komponente mit der Ableitung der Übertragungsfunktion und dem Parameter $k_{Mvel}$ sein. Der dritte Term kann lediglich die Multiplikation der Ableitung der Übertragungsfunktion mit $k_{Mstat}$ oder $k_{Mconst}$ umfassen.

Die einer Gleichung für eine Komponente hinzuzufügenden Terme können somit vorbestimmt sein und insbesondere daran festgemacht werden, ob die Komponente eine translatorische oder rotatorische Bewegung ausführt. Dementsprechend kann aus dem Modell, insbesondere automatisch und/oder generisch, beispielsweise durch die Steuereinheit der Maschine, ermittelt werden, ob die Komponente eine translatorische Bewegung oder eine Drehbewegung ausführt. Danach können dann die entsprechenden Terme, insbesondere automatisch, den Gleichungen des Gleichungssystems hinzugefügt werden.

Gemäß einer weiteren vorteilhaften Ausführungsform werden die ermittelte Bewegungsgröße und/oder die ermittelte dynamische Größe gemessen und/oder aus einem gemessenen Wert berechnet. Insbesondere kann die ermittelte Bewegungsgröße und/oder die ermittelte dynamische Größe aus einem Motordrehmoment berechnet werden. Beispielsweise wird das von dem Motor an die Mechanik abgegebene Drehmoment durch eine Multiplikation des vom Motor aufgenommenen Stroms mit einer Drehmomentkonstanten des Motors und gegebenenfalls einer weiteren Multiplikation mit einem Getriebefaktor berechnet. Das Drehmoment des Motors, welches an die Mechanik abgegeben bzw. übertragen wird, kann die ermittelte dynamische Größe sein. Die ermittelte Bewegungsgröße hingegen kann beispielsweise die Winkelposition des Motors bzw. der Motorwelle sein und direkt gemessen werden. Durch Bestimmung der ersten und zweiten Ableitung der Winkelposition können dann die Winkelgeschwindigkeit und/oder die Winkelbeschleunigung des Motors berechnet werden. Alternativ kann die Winkelposition auch indirekt abgeleitet oder berechnet werden.

Gemäß einer weiteren vorteilhaften Ausführungsform wiederholt sich die Bewegung der Mechanik nach einem Maschinenzyklus, wobei die Ermittlung der Bewegungsgröße und/oder der dynamischen Größe bevorzugt verteilt über den gesamten Maschinenzyklus erfolgt, beispielsweise in Zeitintervallen von kleiner 1 Sekunde, bevorzugt von kleiner 0,1 Sekunden, besonders bevorzugt von kleiner 0,001 Sekunden.

Der Maschinenzyklus ist also definiert als die Bewegung, welche durchlaufen wird, bis sich die Bewegung der Mechanik wiederholt. Dies kann beispielsweise der Fall sein, wenn ein Förderband einen kompletten Umlauf zurückgelegt hat oder eine Abfolge von wiederkehrenden Stanzvorgängen einmalig abgeschlossen wurde. Innerhalb eines Maschinenzyklus kann der Motor eine Vielzahl von Umdrehungen ausführen. Zudem können innerhalb des Maschinenzyklus unterschiedliche Geschwindigkeiten, Beschleunigungen etc. der Komponenten beobachtet werden. Durch die somit vorherrschenden verschiedenen Randbedingungen innerhalb des Maschinenzyklus können die mechanischen Parameter ermittelt werden.

Gemäß einer weiteren vorteilhaften Ausführungsform erfolgt eine Neubestimmung der mechanischen Parameter, wenn sich die ermittelte Bewegungsgröße und/oder die ermittelte dynamische Größe verändert, beispielsweise um mehr als 10 % oder um mehr als 15 %. Die mechanischen Parameter können beispielsweise einmalig bestimmt werden und die ermittelten Werte der Parameter dann im weiteren Betrieb der Maschine genutzt werden. Um die mechanischen Parameter an schleichende Veränderungen, z.B. bedingt durch allmähliche Abnutzung der Maschine, anzupassen und damit auf dem neuesten Stand zu halten, kann eine Neubestimmung der mechanischen Parameter erfolgen. Alternativ oder zusätzlich kann eine Neubestimmung auch dann erfolgen, wenn absichtliche Veränderungen an der Maschine vorgenommen werden, beispielsweise durch einen Produktwechsel, durch den Austausch oder den Ersatz einer Komponente, Wartungsarbeiten und dergleichen.

Gemäß einer weiteren vorteilhaften Ausführungsform umfasst das Modell der Mechanik einen digitalen Zwilling ("digital Twin"). Der digitale Zwilling kann beispielsweise mit Hilfe einer Software wie *industrialPhysics* z.B. auf Basis des CAD-Designs der Maschine erzeugt werden. Der digitale Zwilling stellt somit ein Simulationsmodell der Maschine dar, mit dem die Bewegungen der Komponenten der Mechanik simuliert werden können. Der digitale Zwilling kann

**EP 3 754 837 B1**

wiederholt durch die an der realen Maschine bestimmten mechanischen Parameter angepasst werden, wodurch der digitale Zwilling den realen Bedingungen in der Maschine nachgeführt werden kann. Das Simulationsmodell kann aus einem Maschinen-Projekt generiert werden, sodass die Erstellung des Simulationsmodells mit geringem Aufwand verbunden ist. Bei dem Maschinen-Projekt kann es sich um ein Projekt aus einer Planungssoftware (z.B. einer CAD-Software) für die Maschine handeln. In der Planungssoftware können die Funktion und die Anordnung der Komponenten jeweils festgelegt und dargestellt werden.

Gemäß einer weiteren vorteilhaften Ausführungsform wird für zumindest einen mechanischen Parameter mehrmals ein Wert ermittelt. Dabei wird zunächst zumindest ein mechanischer Parameter als Startwert festgelegt, wobei der Startwert für eine Vorsteuerung der Maschine verwendet wird. Danach wird (bei laufender Vorsteuerung) der mechanische Parameter erneut bestimmt (und bevorzugt als neuer Startwert für die Vorsteuerung der Maschine verwendet), wobei durch die Vorsteuerung ein Rauschen in den Messwerten verringert wird, wodurch dann wiederum die mechanischen Parameter genauer bestimmt werden können. Dieser Vorgang kann wiederholt durchgeführt werden.

Gemäß einer weiteren vorteilhaften Ausführungsform erfolgt aufgrund zumindest eines der mechanischen Parameter eine Veränderung der Steuerung des Motors. Da aufgrund der ermittelten mechanischen Parameter beispielsweise bekannt sein kann, in welchem Bereich des Maschinenzyklus eine erhöhte Reibung auftritt, kann somit vorausschauend die zu erwartende erhöhte Reibung z.B. durch einen gezielten Eingriff in die Steuerung des Motors kompensiert werden. Allgemein kann also eine Vorsteuerung des Motors und insbesondere des Motordrehmoments erfolgen. Hierdurch kann ein verbesserter Gleichlauf, eine erhöhte Laufruhe und Positioniergenauigkeit erreicht werden. Durch den ruhigeren Lauf der Mechanik können u.a. Verschleißerscheinungen der Mechanik gemindert oder auch die Qualität des bearbeiteten oder herzustellenden Produkts verbessert werden.

Ebenso ist es möglich, aufgrund zumindest eines mechanischen Parameters z.B. eine vorausschauende Wartung ("predictive Maintenance") durchzuführen. Dies kann beispielsweise dann angezeigt sein, wenn der Wert des mechanischen Parameters plötzlich stark ansteigt und/oder abfällt oder sich sonstwie ungewöhnlich verändert. So kann beispielsweise ein Anstieg oder Absinken um mehr als 20 % innerhalb eines vorbestimmten Zeitintervalls (z.B. 1 Stunde oder 1 Tag) als Kriterium verwendet werden, um eine vorausschauende Wartung auszulösen.

Eine solche vorausschauende Wartung ist insbesondere deshalb möglich, da für alle Komponenten einzelne mechanische Parameter bestimmt werden, und somit detektiert und lokalisiert werden kann, an welcher Komponente z.B. gerade eine erhöhte Reibung aufgrund eines abgenutzten Lagers auftritt. Weiter beispielhaft können z.B. durch den Anstieg von $k_{Mconst}$ oder $k_{Fconst}$ das Auftreffen einer Komponente auf ein Hindernis oder durch den Anstieg von $k_{MVel}$ oder $k_{FVel}$ eine nachlassende Schmierung erkannt werden.

Schließlich ist es auch möglich, zumindest einen oder mehrere der mechanischen Parameter auszugeben und insbesondere eine statistische Auswertung der mechanischen Parameter durchzuführen. Hierdurch können beispielsweise Schwachstellen der Mechanik erkannt werden. Auch ist es möglich, Rückschlüsse auf ähnliche oder baugleiche Maschinen zu ziehen und die ähnlichen oder baugleichen Maschinen einer notwendigen Wartung oder Veränderung zu unterziehen.

Für die erfindungsgemäße industrielle Maschine nach Anspruch 15 gelten die zum erfindungsgemäßen Verfahren getroffenen Aussagen entsprechend. Dies gilt insbesondere für Vorteile und bevorzugte Ausführungsformen.

Nachfolgend wird die Erfindung rein beispielhaft unter Bezugnahme auf die Zeichnungen beschrieben. Es zeigen:

Fig. 1: den schematischen Aufbau einer Maschine;

Fig. 2: ein Matrix-Gleichungssystem zur Bestimmung von mechanischen Parametern der Maschine.

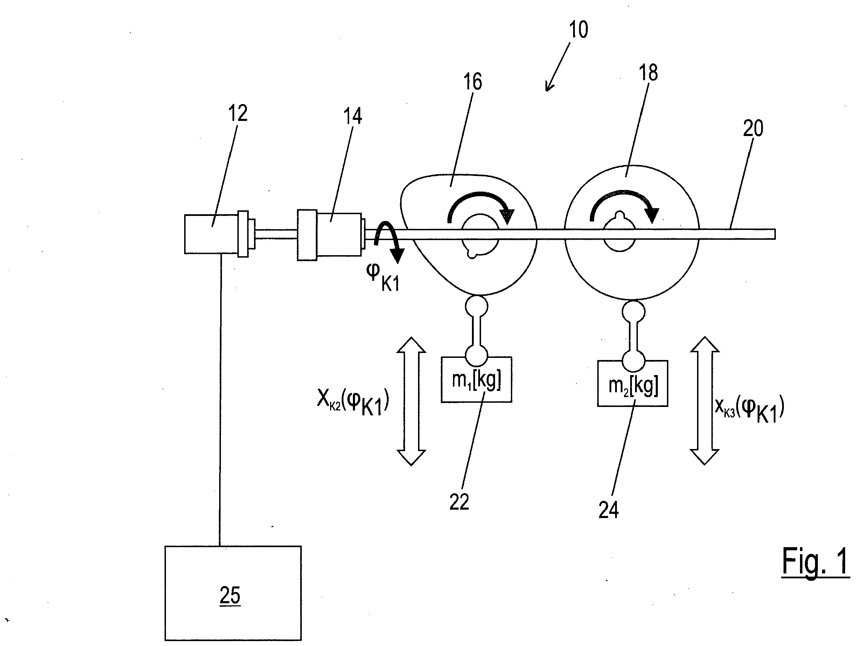

Fig. 1 zeigt eine Maschine 10, welche einen Motor 12, ein mit dem Motor 12 gekoppeltes Getriebe 14, eine erste Nockenscheibe 16 und eine zweite Nockenscheibe 18 umfasst. Das Getriebe 14 treibt die Nockenscheiben 16, 18 mittels einer Antriebswelle 20 rotatorisch an.

Die erste Nockenscheibe 16 wiederum bewegt ein erstes Gewicht 22 und die zweite Nockenscheibe 18 bewegt ein zweites Gewicht 24. Beide Gewichte 22, 24 werden translatorisch und gegen die Schwerkraft bewegt.

Die Kombination aus Motor 12, Getriebe 14, Antriebswelle 20 und Nockenscheiben 16, 18 wird nachfolgend als erste Komponente K1 der Maschine 10 angesehen. Das erste Gewicht 22 ist eine zweite Komponente K2 und das zweite Gewicht 24 eine dritte Komponente K3 der Maschine 10.

Der hier gezeigte Aufbau der Maschine 10 ist rein exemplarisch zu verstehen und dient nur der Verdeutlichung des Verfahrens zur Berechnung der mechanischen Parameter. Grundsätzlich können bei der angegebenen Vorgehensweise mechanische Parameter von beliebig aufgebauten, insbesondere auch komplexen Maschinen bestimmt werden.

Der Motor 12 wird durch eine Steuereinheit 25 angesteuert. Die Steuereinheit 25 bewirkt, dass der Motor 12 über der Zeit unterschiedliche Drehzahlen und Drehmomente an die Antriebswelle 20 abgibt. Die zeitlich veränderliche Drehung der Antriebswelle 20 ist in Fig. 1 durch die Funktion $\varphi_{K1}$ angedeutet.

Die Steuereinheit 25 misst einen vom Motor 12 aufgenommenen Strom und berechnet hieraus das vom Motor 12 jeweils an die Antriebswelle 20 abgegebene Drehmoment. Zudem misst die Steuereinheit 25 (z.B. über einen nicht gezeigten Encoder) die jeweils momentane Winkelposition der Motorwelle des Motors 12. Aus der Änderung der Winkelposition über der Zeit berechnet die Steuereinheit 25 dann eine Winkelgeschwindigkeit und eine Winkelbeschleunigung des Motors 12 und/oder der Antriebswelle 20.

In der Steuereinheit 25 oder auch in einem hier nicht dargestellten externen System wird ein Modell der Mechanik der Maschine 10 vorgehalten. Mittels des Modells kann aus der jeweiligen Winkelposition des Motors 12 basierend auf einer bekannten Getriebeübersetzung auf die jeweilige Winkelposition der Nockenscheiben 16, 18 rückgeschlossen werden. Aus der Winkelposition der Nockenscheiben 16, 18 kann dann die Position, Geschwindigkeit und Beschleunigung der Gewichte 22, 24 berechnet werden. Die Berechnung erfolgt für das erste Gewicht 22 mittels einer Übertragungsfunktion $x_{K2}(\varphi_{K1})$ und für das zweite Gewicht 24 mittels einer Übertragungsfunktion $x_{K3}(\varphi_{K1})$. Die Eingangsgröße für die Übertragungsfunktionen $x_{K2}$, $x_{K3}$ ist jeweils die Drehung der Antriebswelle 20, d.h. die Funktion $\varphi_{K1}$.

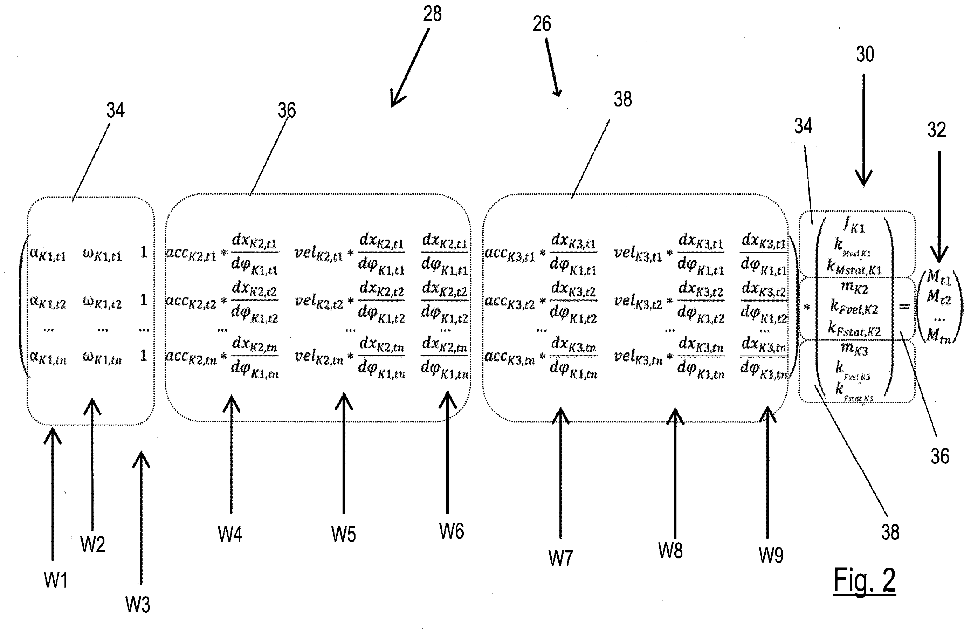

Fig. 2 zeigt ein erfindungsgemäßes Matrix-Gleichungssystem 26. Das Matrix-Gleichungssystem 26 umfasst eine Matrix 28, welche mit einem ersten Vektor 30 multipliziert wird. Bei dieser Multiplikation ergibt sich ein zweiter Vektor 32.

In einer jeweiligen Zeile der Matrix 28 sind jeweils gemessene bzw. daraus ermittelte Werte für denselben Zeitpunkt eingetragen. Die ersten drei Werte (W1, W2, W3) jeder Zeile beziehen sich dabei auf die erste Komponente K1.

Die Werte 4-6 (W4, W5, W6) jeder Zeile beziehen sich auf die Bewegung des ersten Gewichts 22 (d.h. der zweiten Komponente K2), wohingegen die Werte 7-9 (W7, W8, W9) sich auf die Bewegung des zweiten Gewichts 24 und damit auf die dritte Komponente K3 beziehen.

Die zu der ersten Komponente K1 gehörigen Werte sind in der Matrix 28 als erster Bereich 34 gekennzeichnet. Dementsprechend sind die zu dem ersten Gewicht 22 gehörigen Werte als zweiter Bereich 36 und die zu dem zweiten Gewicht 24 gehörigen Werte als dritter Bereich 38 markiert.

Der erste Wert W1 einer jeden Zeile definiert die Winkelbeschleunigung $\alpha$ bei der Rotation der Antriebswelle 20. Der zweite Wert W2 ist die Winkelgeschwindigkeit $\omega$ bei der Rotation der Antriebswelle 20. Der dritte Wert W3 ist konstant 1.

Der vierte und siebte Wert W4, W7 gibt jeweils eine Beschleunigung acc eines der Gewichte 22, 24 an, welcher mit einer Ableitung der Übertragungsfunktion (z.B. $\dfrac{dx_{K2,t1}}{d\varphi_{K1,t1}}$ ) multipliziert wird. Der fünfte und achte Wert W5, W8 gibt jeweils eine Geschwindigkeit *vel* des ersten Gewichts 22 bzw. des zweiten Gewichts 24 an, welche ebenfalls mit einer Ableitung der Übertragungsfunktion multipliziert wird. Schließlich gibt der sechste und neunte Wert W6, W9 einer jeden Zeile lediglich die Ableitung der Übertragungsfunktion für das erste Gewicht 22 bzw. das zweite Gewicht 24 an.

Die zu bestimmenden mechanischen Parameter, d.h. die Unbekannten des Matrix-Gleichungssystems 26, sind in dem Vektor 30 enthalten. Die erste Variable des Vektors 30 repräsentiert ein Trägheitsmoment $J_{K1}$ der ersten Komponente. Die zweite Variable des Vektors 30 ist ein Parameter $k_{Mvel,K1}$, welche ein von der Drehgeschwindigkeit abhängiges Drehmoment angibt. Die dritte Variable gibt ein statische Drehmoment $k_{Mstat,K1}$ (beispielsweise durch Reibung) an. Die ersten drei Variablen beschreiben damit die erste Komponente K1.

Die vierte bis sechste Variable des ersten Vektors 30 beschreibt das erste Gewicht 22 bzw. dessen Bewegungsverhalten. Die vierte Variable repräsentiert die Masse $m_{K2}$ des ersten Gewichts 22, die fünfte Variable beschreibt eine geschwindigkeitsabhängige Kraft $k_{Fvel,K2}$ und die sechste Variable beschreibt eine statische Kraft $k_{Fstat,K2}$, die durch das erste Gewicht 22 erzeugt wird.

In entsprechender Weise beschreibt die siebte Variable die Masse $m_{K3}$ des zweiten Gewichts 24, die achte Variable eine geschwindigkeitsabhängige Kraft $k_{Fvel,K3}$ und die neunte Variable eine konstante Kraft $k_{Fconst,K3}$. Dementsprechend sind die Variablen 1-3 dem ersten Bereich 34, die Variablen 4-6 dem zweiten Bereich 36 und die Variablen 7-9 dem dritten Bereich 38 zugeordnet.

In dem zweiten Vektor 32 sind für den in einer jeweiligen Zeile repräsentierten Zeitpunkt (t1, t2, ..., tn) die zu diesem Zeitpunkt vom Motor 12 eingebrachten und gemessenen Drehmomente $M_{t1}$ bis $M_{tn}$ angegeben.

Beim Lösen des Matrix-Gleichungssystems 26 entsteht für jede Zeile der Matrix 28 eine Gleichung mit neun Unbekannten (den neun Variablen des ersten Vektors 30). Die übrigen Werte wurden entweder gemessen oder anhand des Modells der Mechanik berechnet, wie oben ausgeführt.

Durch Multiplikation beider Seiten des Matrix-Gleichungssystems 26 mit der Transponierten der Matrix 28 lässt sich das Matrix-Gleichungssystem 26 eindeutig lösen.

Insbesondere werden zu einer Vielzahl von Zeitpunkten z.B. innerhalb eines Maschinenzyklus oder innerhalb mehrerer Maschinenzyklen, beispielsweise mehr als 1.000 oder mehr als 10.000 Messungen durchgeführt. Für jede Messung wird eine Zeile in dem Matrix-Gleichungssystem 26 erzeugt, wobei in die Zeile die zu dem jeweiligen Zeitpunkt gemessenen bzw. berechneten Werte eingetragen werden. Dementsprechend kann die Matrix 28 und damit auch der zweite Vektor 32 mehr als 1.000 oder mehr als 10.000 Zeilen umfassen.

Auf diese Weise kann allein durch die Messung des vom Motor 12 erzeugten Drehmoments und der Messung der Position des Motors 12 eine Aussage über die mechanischen Parameter sämtlicher Komponenten der Maschine 10 getroffen werden. Der Motor 12 zusammen mit der Steuereinheit 25 dient somit als einziges Messgerät. Durch die Messungen des Motors 12 können zu jedem Zeitpunkt die in der Matrix 28 zusammengefassten Bewegungsgrößen ermittelt werden, wodurch dann wiederum die mechanischen Parameter 30 bestimmt werden können. Durch die mechanischen Parameter lässt sich das Verhalten der Mechanik der Maschine vorhersagen, wodurch eine Vorsteuerung des Motors 12 erfolgen kann. Die Laufeigenschaften der Maschine 10 können hierdurch deutlich verbessert werden. Zudem können z.B. kleinere/leichtere Motoren 12 als herkömmlich verwendet werden, sodass Kosten beim Motor 12 und auch der Energieverbrauch beim Betrieb der Maschine 10 deutlich reduziert werden können.

Zudem besteht der Vorteil, dass die mechanischen Parameter 30 jeweils einer definierten Komponente zugeordnet sind, sodass auch z.B. bei komplexen Antriebssträngen u.a. im laufenden Betrieb allein durch die Messung am Motor 12 erkannt werden kann, bei welcher Komponente z.B. eine erhöhte Reibung momentan auftritt. Diese Komponente kann dann gezielt z.B. gewartet werden, wodurch die Arbeit von Instandhaltungspersonal vereinfacht wird. Damit ist es möglich, insbesondere in der Betriebsphase einer Maschine 10 das Sollverhalten der Maschine 10 gemäß dem Maschinendesign mit dem realen / aktuellen Verhalten jederzeit zu vergleichen, Abweichungen zu erkennen und gezielte Gegenmaßnahmen z.B. in Echtzeit durch Vorsteuerung des Antriebmoments des Motors 12 einzuleiten.

Bezugszeichenliste

| 10 | Maschine |
| 12 | Motor |
| 14 | Getriebe |
| 16 | erste Nockenscheibe |
| 18 | zweite Nockenscheibe |
| 20 | Antriebswelle |
| 22 | erstes Gewicht |
| 24 | zweites Gewicht |
| 25 | Steuereinheit |
| 26 | Matrix-Gleichungssystem |
| 28 | Matrix |
| 30 | erster Vektor |
| 32 | zweiter Vektor |
| 34 | erster Bereich |
| 36 | zweiter Bereich |
| 38 | dritter Bereich |

| $\varphi_{K1}$ | Funktion der Drehung der Antriebswelle |
| $x_{K2}(\varphi_{K1})$ | erste Übertragungsfunktion |
| $x_{K3}(\varphi_{K1})$ | zweite Übertragungsfunktion |
| K1 | erste Komponente |
| K2 | zweite Komponente |
| K3 | dritte Komponente |
| W1-W9 | erster bis neunter Wert |

**Patentansprüche**

1. Verfahren zur Überwachung einer Maschine (10), bei welcher eine Mechanik durch einen Motor (12) bewegt wird, wobei die Mechanik mehr als zwei miteinander gekoppelte Komponenten (K1, K2, K3) umfasst, wobei eine der Komponenten (K1, K2, K3) den Motor (12) umfasst, wobei zumindest zwei der Komponenten (K1, K2, K3) sich unterschiedlich bewegen, wenn der Motor (12) die Mechanik antreibt, wobei

- zumindest eine Bewegungsgröße (W1-W9) einer der Komponenten (K1, K2, K3) der Mechanik wiederholt ermittelt wird,
- zumindest eine dynamische Größe (32) einer der Komponenten (K1, K2, K3) der Mechanik wiederholt ermittelt wird,
- mittels eines Modells der Mechanik die Bewegungsgrößen (W1-W9) der übrigen Komponenten (K1, K2, K3) der Mechanik berechnet werden,
- aus der ermittelten Bewegungsgröße (W1-W9), der ermittelten dynamischen Größe und den berechneten Bewegungsgrößen (W1-W9) separate mechanische Parameter (30) für die Komponenten (K1, K2, K3) der Mechanik bestimmt werden,

**gekennzeichnet dadurch dass** die mechanischen Parameter (30) durch ein Matrix-Gleichungssystemder Form

$$A * (MP) = (M)$$

wobei A durch

$$\begin{pmatrix} \alpha_{K1,t1} & \omega_{K1,t1} & 1 & acc_{K2,t1} * \frac{dx_{K2,t1}}{d\varphi_{K1,t1}} & vel_{K2,t1} * \frac{dx_{K2,t1}}{d\varphi_{K1,t1}} & \frac{dx_{K2,t1}}{d\varphi_{K1,t1}} & \alpha_{K3,t1} * \frac{d\varphi_{K3,t1}}{d\varphi_{K1,t1}} & \omega_{K3,t1} * \frac{d\varphi_{K3,t1}}{d\varphi_{K1,t1}} & \frac{d\varphi_{K3,t1}}{d\varphi_{K1,t1}} \\ \alpha_{K1,t2} & \omega_{K1,t2} & 1 & acc_{K2,t2} * \frac{dx_{K2,t2}}{d\varphi_{K1,t2}} & vel_{K2,t2} * \frac{dx_{K2,t2}}{d\varphi_{K1,t2}} & \frac{dx_{K2,t2}}{d\varphi_{K1,t2}} & \alpha_{K3,t2} * \frac{d\varphi_{K3,t2}}{d\varphi_{K1,t2}} & \omega_{K3,t2} * \frac{d\varphi_{K3,t2}}{d\varphi_{K1,t2}} & \frac{d\varphi_{K3,t2}}{d\varphi_{K1,t2}} \\ ... & ... & ... & ... & ... & ... & ... & ... & ... \\ \alpha_{K1,tn} & \omega_{K1,tn} & 1 & acc_{K2,tn} * \frac{dx_{K2,tn}}{d\varphi_{K1,tn}} & vel_{K2,tn} * \frac{dx_{K2,tn}}{d\varphi_{K1,tn}} & \frac{dx_{K2,tn}}{d\varphi_{K1,tn}} & \alpha_{K3,tn} * \frac{d\varphi_{K3,tn}}{d\varphi_{K1,tn}} & \omega_{K3,tn} * \frac{d\varphi_{K3,tn}}{d\varphi_{K1,tn}} & \frac{d\varphi_{K3,tn}}{d\varphi_{K1,tn}} \end{pmatrix}$$

(MP) durch

$$\begin{pmatrix} J_{K1} \\ k_{Mvel,K1} \\ k_{Mstat,K1} \\ m_{K2} \\ k_{Fvel,K2} \\ k_{Fstat,K2} \\ J_{K3} \\ k_{Mvel,K3} \\ k_{Mstat,K3} \end{pmatrix}$$

und
(M) durch

$$\begin{pmatrix} M_{t1} \\ M_{t2} \\ ... \\ M_{tn} \end{pmatrix}$$

dargestellt wird,
wobei A eine Matrix der Bewegungsgrößen (W1-W9), (MP) ein Vektor mit den zu ermittelnden mechanischen Parametern (30) und (M) ein Vektor der dynamischen Größen (32), wobei der Vektor Drehmomente umfasst, welche jeweils dem vom Motor (12) zu einem Zeitpunkt abgegebenen Drehmoment entsprechen, ist,
wobei
$\alpha$ eine Winkelbeschleunigung,
J ein Trägheitsmoment,
$\omega$ eine Winkelgeschwindigkeit,
k ein Parameter,
dx/d$\varphi$ und d$\varphi$/d$\varphi$ Ableitungen von Übertragungsfunkionen,
acc eine Beschleunigung und
vel eine Geschwindigkeit ist.

**2.** Verfahren nach Anspruch 1,
wobei die Vielzahl von Werten der ermittelten Bewegungsgröße (W1-W9) und/oder der ermittelten dynamischen Größe herangezogen wird, um die mechanischen Parameter (30) für die Komponenten (K1, K2, K3) der Mechanik zu bestimmen.

**3.** Verfahren nach Anspruch 1 oder 2,
wobei das MatrixGleichungssystem mit einer Vielzahl von Gleichungen, bevorzugt mit einer Gleichung pro Wert der ermittelten Bewegungsgröße (W1-W9), aufgestellt und gelöst wird, um die mechanischen Parameter (30) zu bestimmen.

**4.** Verfahren nach einem der vorstehenden Ansprüche,
wobei die Bewegungsgröße (W1-W9) eine Geschwindigkeit, eine Position, eine Beschleunigung, eine Winkelgeschwindigkeit, eine Winkelposition und/oder eine Winkelbeschleunigung umfasst.

**5.** Verfahren nach einem der vorstehenden Ansprüche,
wobei das Modell der Mechanik zumindest eine Übertragungsfunktion ($x_1$, $x_2$) umfasst, welche die Bewegung einer ersten Komponente (K1, K2, K3) in Abhängigkeit der Bewegung einer zweiten Komponente (K1, K2, K3), welche mit der ersten Komponente (K1, K2, K3) gekoppelt ist, beschreibt.

**6.** Verfahren nach Anspruch 5,
wobei die Bewegungsgrößen (W1-W9) jeweils mit einer Ableitung der Übertragungsfunktion, welche die Bewegung der jeweiligen Komponente (K1, K2, K3) beschreibt, multipliziert werden.

**7.** Verfahren nach einem der vorstehenden Ansprüche,
wobei die mechanischen Parameter (30) ein Drehmoment und/oder eine Kraft und/oder einen Parameter zur Berechnung eines Drehmoments oder einer Kraft basierend insbesondere auf einer Beschleunigung oder Geschwindigkeit umfassen.

**8.** Verfahren nach einem der vorstehenden Ansprüche,
wobei das Verfahren mehrmals, inbesondere zwei Mal, separat ausgeführt wird, um mechanische Parameter (30) für unterschiedliche Bewegungsrichtungen einer Komponente (K1, K2, K3) zu bestimmen.

**9.** Verfahren nach einem der vorstehenden Ansprüche,
wobei die ermittelte Bewegungsgröße (W1-W9) und/oder die ermittelte dynamische Größe (32) gemessen und/oder aus einem gemessenen Wert berechnet werden, insbesondere aus einem Motordrehmoment.

**10.** Verfahren nach einem der vorstehenden Ansprüche,
wobei eine Neubestimmung der mechanischen Parameter (30) erfolgt, wenn sich die ermittelte Bewegungsgröße (W1-W9) und/oder die ermittelte dynamische Größe (32) verändert, beispielsweise um mehr als 10% oder um mehr als 15%.

**11.** Verfahren nach einem der vorstehenden Ansprüche,
wobei das Modell der Mechanik einen digitalen Zwilling umfasst.

**12.** Verfahren nach einem der vorstehenden Ansprüche,
wobei ein Wert für zumindest einen mechanischen Parameter (30) mehrmals bestimmt wird und aus den mehreren Werten ein Endwert für den mechanischen Parameter (30) errechnet wird.

**13.** Verfahren nach einem der vorstehenden Ansprüche,
wobei aufgrund zumindest eines der mechanischen Parameter (30) eine Veränderung der Steuerung des Motors (12) erfolgt.

**14.** Verfahren nach einem der vorstehenden Ansprüche,
wobei aufgrund zumindest eines mechanischen Parameters (30) eine vorausschauende Wartung der Maschine (10) durchgeführt wird.

**15.** Industrielle Maschine (10) mit einer Mechanik, welche einen Motor (12) und zumindest zwei weitere Komponenten (K1, K2, K3) umfasst, wobei die Komponenten (K1, K2, K3) miteinander gekoppelt sind, wobei zumindest die zwei Komponenten (K1, K2, K3) sich unterschiedlich bewegen, wenn der Motor (12) die Mechanik antreibt, wobei die Maschine (10) zumindest einen Sensor und eine Recheneinrichtung (25) umfasst und ausgestaltet ist,

- zumindest eine Bewegungsgröße (W1-W9) einer der Komponenten (K1, K2, K3) der Mechanik wiederholt zu ermitteln,
- zumindest eine dynamische Größe (32) einer der Komponenten (K1, K2, K3) der Mechanik wiederholt zu ermitteln,
- mittels eines Modells der Mechanik die Bewegungsgrößen (W1-W9) der übrigen Komponenten (K1, K2, K3) der Mechanik zu berechnen,
- aus der ermittelten Bewegungsgröße (W1-W9), der ermittelten dynamischen Größe und den berechneten Bewegungsgrößen (W1-W9) separate mechanische Parameter (30) für die Komponenten (K1, K2, K3) der Mechanik zu bestimmen,

**dadurch gekennzeichnet dass** die Maschine (10) ausgebildet ist, die mechanischen Parameter (30) durch ein Matrix-Gleichungssystem der Form

$$\mathbf{A} * (MP) = (M)$$

zu berechnen,

wobei A durch

$$\begin{pmatrix} \alpha_{K1,t1} & \omega_{K1,t1} & 1 & acc_{K2,t1} * \frac{dx_{K2,t1}}{d\varphi_{K1,t1}} & vel_{K2,t1} * \frac{dx_{K2,t1}}{d\varphi_{K1,t1}} & \frac{dx_{K2,t1}}{d\varphi_{K1,t1}} & \alpha_{K3,t1} * \frac{d\varphi_{K3,t1}}{d\varphi_{K1,t1}} & \omega_{K3,t1} * \frac{d\varphi_{K3,t1}}{d\varphi_{K1,t1}} & \frac{d\varphi_{K3,t1}}{d\varphi_{K1,t1}} \\ \alpha_{K1,t2} & \omega_{K1,t2} & 1 & acc_{K2,t2} * \frac{dx_{K2,t2}}{d\varphi_{K1,t2}} & vel_{K2,t2} * \frac{dx_{K2,t2}}{d\varphi_{K1,t2}} & \frac{dx_{K2,t2}}{d\varphi_{K1,t2}} & \alpha_{K3,t2} * \frac{d\varphi_{K3,t2}}{d\varphi_{K1,t2}} & \omega_{K3,t2} * \frac{d\varphi_{K3,t2}}{d\varphi_{K1,t2}} & \frac{d\varphi_{K3,t2}}{d\varphi_{K1,t2}} \\ ... & ... & ... & ... & ... & ... & ... & ... & ... \\ \alpha_{K1,tn} & \omega_{K1,tn} & 1 & acc_{K2,tn} * \frac{dx_{K2,tn}}{d\varphi_{K1,tn}} & vel_{K2,tn} * \frac{dx_{K2,tn}}{d\varphi_{K1,tn}} & \frac{dx_{K2,tn}}{d\varphi_{K1,tn}} & \alpha_{K3,tn} * \frac{d\varphi_{K3,tn}}{d\varphi_{K1,tn}} & \omega_{K3,tn} * \frac{d\varphi_{K3,tn}}{d\varphi_{K1,tn}} & \frac{d\varphi_{K3,tn}}{d\varphi_{K1,tn}} \end{pmatrix}$$

(MP) durch

$$\begin{pmatrix} J_{K1} \\ k_{Mvel,K1} \\ k_{Mstat,K1} \\ m_{K2} \\ k_{Fvel,K2} \\ k_{Fstat,K2} \\ J_{K3} \\ k_{Mvel,K3} \\ k_{Mstat,K3} \end{pmatrix}$$

und
(M) durch

$$\begin{pmatrix} M_{t1} \\ M_{t2} \\ ... \\ M_{tn} \end{pmatrix}$$

dargestellt wird,
wobei A eine Matrix der Bewegungsgrößen (W1-W9), (MP) ein Vektor mit den zu ermittelnden mechanischen Parametern (30) und (M) ein Vektor der dynamischen Größen (32), wobei der Vektor Drehmomente umfasst, welche jeweils dem vom Motor (12) zu einem Zeitpunkt abgegebenen Drehmoment entsprechen, ist,

wobei

$\alpha$ eine Winkelbeschleunigung,

J ein Trägheitsmoment,

$\omega$ eine Winkelgeschwindigkeit,

k ein Parameter,

$dx/d\varphi$ und $d\varphi/d\varphi$ Ableitungen von Übertragungsfunkionen,

acc eine Beschleunigung und

vel eine Geschwindigkeit ist.

**Claims**

1. A method of monitoring a machine (10) in which a mechanical system is moved by a motor (12), wherein the mechanical system comprises more than two components (K1, K2, K3) coupled to one another, wherein one of the components (K1, K2, K3) comprises the motor (12), wherein at least two of the components (K1, K2, K3) move differently when the motor (12) drives the mechanical system, and wherein

- at least one movement factor (W1-W9) of one of the components (K1, K2, K3) of the mechanical system is determined repeatedly;
- at least one dynamic factor (32) of one of the components (K1, K2, K3) of the mechanical system is determined repeatedly;
- the movement factors (W1-W9) of the remaining components (K1, K2, K3) of the mechanical system are calculated by means of a model of the mechanical system; and
- separate mechanical parameters (30) for the components (K1, K2, K3) of the mechanical system are determined from the determined movement factor (W1-W9), from the determined dynamic factor and from the calculated movement factors (W1-W9),

**characterized in that**

the mechanical parameters (30) are calculated by a matrix equation system in the form

$$A * (MP) = (M),$$

where A is represented by

$$\begin{pmatrix} \alpha_{K1,t1} & \omega_{K1,t1} & 1 & acc_{K2,t1} * \frac{dx_{K2,t1}}{d\varphi_{K1,t1}} & vel_{K2,t1} * \frac{dx_{K2,t1}}{d\varphi_{K1,t1}} & \frac{dx_{K2,t1}}{d\varphi_{K1,t1}} & \alpha_{K3,t1} * \frac{d\varphi_{K3,t1}}{d\varphi_{K1,t1}} & \omega_{K3,t1} * \frac{d\varphi_{K3,t1}}{d\varphi_{K1,t1}} & \frac{d\varphi_{K3,t1}}{d\varphi_{K1,t1}} \\ \alpha_{K1,t2} & \omega_{K1,t2} & 1 & acc_{K2,t2} * \frac{dx_{K2,t2}}{d\varphi_{K1,t2}} & vel_{K2,t2} * \frac{dx_{K2,t2}}{d\varphi_{K1,t2}} & \frac{dx_{K2,t2}}{d\varphi_{K1,t2}} & \alpha_{K3,t2} * \frac{d\varphi_{K3,t2}}{d\varphi_{K1,t2}} & \omega_{K3,t2} * \frac{d\varphi_{K3,t2}}{d\varphi_{K1,t2}} & \frac{d\varphi_{K3,t2}}{d\varphi_{K1,t2}} \\ ... & ... & ... & ... & ... & ... & ... & ... & ... \\ \alpha_{K1,tn} & \omega_{K1,tn} & 1 & acc_{K2,tn} * \frac{dx_{K2,tn}}{d\varphi_{K1,tn}} & vel_{K2,tn} * \frac{dx_{K2,tn}}{d\varphi_{K1,tn}} & \frac{dx_{K2,tn}}{d\varphi_{K1,tn}} & \alpha_{K3,tn} * \frac{d\varphi_{K3,tn}}{d\varphi_{K1,tn}} & \omega_{K3,tn} * \frac{d\varphi_{K3,tn}}{d\varphi_{K1,tn}} & \frac{d\varphi_{K3,tn}}{d\varphi_{K1,tn}} \end{pmatrix}$$

(MP) is represented by $$\begin{pmatrix} J_{K1} \\ k_{Mvel,K1} \\ k_{Mstat,K1} \\ m_{K2} \\ k_{Fvel,K2} \\ k_{Fstat,K2} \\ J_{K3} \\ k_{Mvel,K3} \\ k_{Mstat,K3} \end{pmatrix}$$ and

(M) is represented by $$\begin{pmatrix} M_{t1} \\ M_{t2} \\ ... \\ M_{tn} \end{pmatrix},$$

where A is a matrix of the movement factors (W1-W9), (MP) is a vector with the mechanical parameters (30) to be determined and (M) is a vector of the dynamic factors (32), wherein the vector comprises torques which correspond to the respective torque delivered by the motor (12) at a point in time,
where
$\alpha$ is an angular acceleration,
J is a moment of inertia,
$\omega$ is an angular speed,
k is a parameter,
dx/dcp and dcp/dcp are derivatives of transfer functions,
acc is an acceleration and
vel is a speed.

2. A method according to claim 1,
wherein the plurality of values of the determined movement factor (W1-W9) and/or of the determined dynamic factor
are used to determine the mechanical parameters (30) for the components (K1, K2, K3) of the mechanical system.

3. A method according to claim 1 or 2,
wherein the matrix equation system having a plurality of equations, preferably having one equation per value of the
determined movement factor (W1-W9), is set up and solved to determine the mechanical parameters (30).

4. A method according to any one of the preceding claims,
wherein the movement factor (W1-W9) comprises a speed; a position; an acceleration; an angular speed; an angular
position; and/or an angular acceleration.

5. A method according to any one of the preceding claims,
wherein the model of the mechanical system comprises at least one transfer function ($x_1$, $x_2$) which describes the
movement of a first component (K1, K2, K3) in dependence on the movement of a second component (K1, K2, K3)
which is coupled to the first component (K1, K2, K3).

6. A method according to claim 5,
wherein the movement factors (W1-W9) are each multiplied by a derivative of the transfer function which describes
the movement of the respective component (K1, K2, K3).

7. A method according to any one of the preceding claims,
wherein the mechanical parameters (30) comprise a torque; and/or a force; and/or a parameter for calculating a
torque or a force in particular based on an acceleration or a speed.

8. A method according to any one of the preceding claims,
wherein the method is performed separately several times, in particular twice, to determine mechanical parameters
(30) for different directions of movement of a component (K1, K2, K3).

9. A method according to any one of the preceding claims,
wherein the determined movement factor (W1-W9) and/or the determined dynamic factor (32) is/are measured
and/or calculated from a measured value, in particular from a motor torque.

10. A method according to any one of the preceding claims,
wherein a new determination of the mechanical parameters (30) takes place when the determined movement factor(W1-W9) and/or the determined dynamic factor (32) changes/change, for example by more than 10% or by more
than 15%.

11. A method according to any one of the preceding claims,
wherein the model of the mechanical system comprises a digital twin.

12. A method according to any one of the preceding claims,
wherein a value for at least one mechanical parameter (30) is determined several times and a final value for the
mechanical parameter (30) is calculated from the plurality of values.

13. A method according to any one of the preceding claims,
wherein a change of the control of the motor (12) takes place on the basis of at least one of the mechanical parameters
(30).

14. A method according to any one of the preceding claims,
wherein a predictive maintenance of the machine (10) is performed on the basis of at least one mechanical parameter (30).

15. An industrial machine (10) having a mechanical system which comprises a motor (12) and at least two further components (K1, K2, K3), wherein the components (K1, K2, K3) are coupled to one another, wherein at least the two components (K1, K2, K3) move differently when the motor (12) drives the mechanical system, and wherein the machine (10) comprises at least one sensor and a processing device (25) and is designed

- to repeatedly determine at least one movement factor (W1-W9) of one of the components (K1, K2, K3) of the mechanical system;
- to repeatedly determine at least one dynamic factor (32) of one of the components (K1, K2, K3) of the mechanical system;
- to calculate the movement factors (W1-W9) of the remaining components (K1, K2, K3) of the mechanical system by means of a model of the mechanical system; and
- to determine separate mechanical parameters (30) for the components (K1, K2, K3) of the mechanical system from the determined movement factor (W1-W9), from the determined dynamic factor and from the calculated movement factors (W1-W9),

**characterized in that**

the machine (10) is configured to calculate the mechanical parameters (30) by a matrix equation system in the form

$$\mathbf{A} * (MP) = (M),$$

where $\mathbf{A}$ is represented by

$$\begin{pmatrix} \alpha_{K1,t1} & \omega_{K1,t1} & 1 & acc_{K2,t1}*\frac{dx_{K2,t1}}{d\varphi_{K1,t1}} & vel_{K2,t1}*\frac{dx_{K2,t1}}{d\varphi_{K1,t1}} & \frac{dx_{K2,t1}}{d\varphi_{K1,t1}} & \alpha_{K3,t1}*\frac{d\varphi_{K3,t1}}{d\varphi_{K1,t1}} & \omega_{K3,t1}*\frac{d\varphi_{K3,t1}}{d\varphi_{K1,t1}} & \frac{d\varphi_{K3,t1}}{d\varphi_{K1,t1}} \\ \alpha_{K1,t2} & \omega_{K1,t2} & 1 & acc_{K2,t2}*\frac{dx_{K2,t2}}{d\varphi_{K1,t2}} & vel_{K2,t2}*\frac{dx_{K2,t2}}{d\varphi_{K1,t2}} & \frac{dx_{K2,t2}}{d\varphi_{K1,t2}} & \alpha_{K3,t2}*\frac{d\varphi_{K3,t2}}{d\varphi_{K1,t2}} & \omega_{K3,t2}*\frac{d\varphi_{K3,t2}}{d\varphi_{K1,t2}} & \frac{d\varphi_{K3,t2}}{d\varphi_{K1,t2}} \\ ... & ... & ... & ... & ... & ... & ... & ... & ... \\ \alpha_{K1,tn} & \omega_{K1,tn} & 1 & acc_{K2,tn}*\frac{dx_{K2,tn}}{d\varphi_{K1,tn}} & vel_{K2,tn}*\frac{dx_{K2,tn}}{d\varphi_{K1,tn}} & \frac{dx_{K2,tn}}{d\varphi_{K1,tn}} & \alpha_{K3,tn}*\frac{d\varphi_{K3,tn}}{d\varphi_{K1,tn}} & \omega_{K3,tn}*\frac{d\varphi_{K3,tn}}{d\varphi_{K1,tn}} & \frac{d\varphi_{K3,tn}}{d\varphi_{K1,tn}} \end{pmatrix}$$

(MP) is represented by 
$$\begin{pmatrix} J_{K1} \\ k_{Mvel,K1} \\ k_{Mstat,K1} \\ m_{K2} \\ k_{Fvel,K2} \\ k_{Fstat,K2} \\ J_{K3} \\ k_{Mvel,K3} \\ k_{Mstat,K3} \end{pmatrix}$$ 
and

(M) is represented by 
$$\begin{pmatrix} M_{t1} \\ M_{t2} \\ ... \\ M_{tn} \end{pmatrix},$$

where $\mathbf{A}$ is a matrix of the movement factors (W1-W9), (MP) is a vector with the mechanical parameters (30) to be determined and (M) is a vector of the dynamic factors (32), wherein the vector comprises torques which correspond to the respective torque delivered by the motor (12) at a point in time,
where
$\alpha$ is an angular acceleration,
J is a moment of inertia,
$\omega$ is an angular speed,
k is a parameter,

dx/dcp and dcp/dcp are derivatives of transfer functions,
acc is an acceleration and
vel is a speed.

**Revendications**

1. Procédé de surveillance d'une machine (10) dans laquelle un mécanisme est déplacé par un moteur (12), le mécanisme comprenant plus de deux composants (K1, K2, K3) couplés les uns aux autres, l'un des composants (K1, K2, K3) comprenant le moteur (12), au moins deux des composants (K1, K2, K3) se déplaçant différemment lorsque le moteur (12) entraîne le mécanisme,
dans lequel

- au moins une grandeur de mouvement (W1-W9) de l'un des composants (K1, K2, K3) du mécanisme est déterminée de manière répétée,
- au moins une grandeur dynamique (32) de l'un des composants (K1, K2, K3) du mécanisme est déterminée de manière répétée,
- les grandeurs de mouvement (W1-W9) des autres composants (K1, K2, K3) du mécanisme sont calculées au moyen d'un modèle du mécanisme,
- des paramètres mécaniques séparés (30) sont définis pour les composants (K1, K2, K3) du mécanisme à partir de la grandeur de mouvement (W1-W9) déterminée, de la grandeur dynamique déterminée et des grandeurs de mouvement (W1-W9) calculées,

**caractérisé en ce que**

les paramètres mécaniques (30) sont calculés par un système d'équations matriciel de la forme

$$A * (MP) = (M)$$

**A** étant représenté par

$$\begin{pmatrix} \alpha_{K1,t1} & \omega_{K1,t1} & 1 & acc_{K2,t1} * \frac{dx_{K2,t1}}{d\varphi_{K1,t1}} & vel_{K2,t1} * \frac{dx_{K2,t1}}{d\varphi_{K1,t1}} & \frac{dx_{K2,t1}}{d\varphi_{K1,t1}} & \alpha_{K3,t1} * \frac{d\varphi_{K3,t1}}{d\varphi_{K1,t1}} & \omega_{K3,t1} * \frac{d\varphi_{K3,t1}}{d\varphi_{K1,t1}} & \frac{d\varphi_{K3,t1}}{d\varphi_{K1,t1}} \\ \alpha_{K1,t2} & \omega_{K1,t2} & 1 & acc_{K2,t2} * \frac{dx_{K2,t2}}{d\varphi_{K1,t2}} & vel_{K2,t2} * \frac{dx_{K2,t2}}{d\varphi_{K1,t2}} & \frac{dx_{K2,t2}}{d\varphi_{K1,t2}} & \alpha_{K3,t2} * \frac{d\varphi_{K3,t2}}{d\varphi_{K1,t2}} & \omega_{K3,t2} * \frac{d\varphi_{K3,t2}}{d\varphi_{K1,t2}} & \frac{d\varphi_{K3,t2}}{d\varphi_{K1,t2}} \\ \cdots & \cdots & \cdots & \cdots & \cdots & \cdots & \cdots & \cdots & \cdots \\ \alpha_{K1,tn} & \omega_{K1,tn} & 1 & acc_{K2,tn} * \frac{dx_{K2,tn}}{d\varphi_{K1,tn}} & vel_{K2,tn} * \frac{dx_{K2,tn}}{d\varphi_{K1,tn}} & \frac{dx_{K2,tn}}{d\varphi_{K1,tn}} & \alpha_{K3,tn} * \frac{d\varphi_{K3,tn}}{d\varphi_{K1,tn}} & \omega_{K3,tn} * \frac{d\varphi_{K3,tn}}{d\varphi_{K1,tn}} & \frac{d\varphi_{K3,tn}}{d\varphi_{K1,tn}} \end{pmatrix}$$

(MP) étant représenté par $\begin{pmatrix} J_{K1} \\ k_{Mvel,K1} \\ k_{Mstat,K1} \\ m_{K2} \\ k_{Fvel,K2} \\ k_{Fstat,K2} \\ J_{K3} \\ k_{Mvel,K3} \\ k_{Mstat,K3} \end{pmatrix}$ et

$$\begin{pmatrix} M_{t1} \\ M_{t2} \\ ... \\ M_{tn} \end{pmatrix}$$

(M) étant représenté par

**A** étant une matrice des grandeurs de mouvement (W1-W9), (MP) étant un vecteur avec les paramètres mécaniques (30) à déterminer, et (M) étant un vecteur des grandeurs dynamiques (32), le vecteur comprenant des couples de rotation qui correspondent chacun au couple de rotation fourni par le moteur (12) à un certain instant,

et

a étant une accélération angulaire,

J étant un couple d'inertie,

ω étant une vitesse angulaire,

k étant un paramètre,

dx/dφ et dφ/dφ étant des dérivées de fonctions de transfert,

acc étant une accélération, et

vel étant une vitesse.

2. Procédé selon la revendication 1,
dans lequel la pluralité de valeurs de la grandeur de mouvement (W1-W9) déterminée et/ou de la grandeur dynamique déterminée est utilisée pour définir les paramètres mécaniques (30) pour les composants (K1, K2, K3) du mécanisme.

3. Procédé selon la revendication 1 ou 2,
dans lequel le système d'équations matriciel et établi et résolu avec une pluralité d'équations, de préférence avec une équation par valeur de la grandeur de mouvement (W1-W9) déterminée, afin de définir les paramètres mécaniques (30).

4. Procédé selon l'une des revendications précédentes,
dans lequel la grandeur de mouvement (W1-W9) comprend une vitesse, une position, une accélération, une vitesse angulaire, une position angulaire et/ou une accélération angulaire.

5. Procédé selon l'une des revendications précédentes,
dans lequel le modèle du mécanisme comprend au moins une fonction de transfert ($x_1$, $x_2$) décrivant le mouvement d'un premier composant (K1, K2, K3) en fonction du mouvement d'un deuxième composant (K1, K2, K3) couplé au premier composant (K1, K2, K3).

6. Procédé selon la revendication 5,
dans lequel les grandeurs de mouvement (W1-W9) sont chacune multipliées par une dérivée de la fonction de transfert décrivant le mouvement du composant respectif (K1, K2, K3).

7. Procédé selon l'une des revendications précédentes,
dans lequel les paramètres mécaniques (30) comprennent un couple de rotation et/ou une force et/ou un paramètre pour calculer un couple de rotation ou une force en se basant en particulier sur une accélération ou une vitesse.

8. Procédé selon l'une des revendications précédentes,
dans lequel le procédé est exécuté séparément plusieurs fois, en particulier deux fois, afin de définir des paramètres mécaniques (30) pour différentes directions de mouvement d'un composant (K1, K2, K3).

9. Procédé selon l'une des revendications précédentes,
dans lequel la grandeur de mouvement (W1-W9) déterminée et/ou la grandeur dynamique (32) déterminée est mesurée et/ou calculée à partir d'une valeur mesurée (W1-W9), en particulier à partir d'un couple de rotation du moteur.

10. Procédé selon l'une des revendications précédentes,
dans lequel une redéfinition des paramètres mécaniques (30) est effectuée lorsque la grandeur de mouvement (W1-W9) déterminée et/ou la grandeur dynamique (32) déterminée varie, par exemple de plus de 10 % ou de plus de 15 %.

11. Procédé selon l'une des revendications précédentes,
dans lequel le modèle du mécanisme comprend un jumeau numérique.

12. Procédé selon l'une des revendications précédentes,
dans lequel une valeur pour au moins un paramètre mécanique (30) est définie plusieurs fois, et une valeur finale pour le paramètre mécanique (30) est calculée à partir desdites plusieurs valeurs.

13. Procédé selon l'une des revendications précédentes,
dans lequel une modification de la commande du moteur (12) est effectuée sur la base de l'un au moins des paramètres mécaniques (30).

14. Procédé selon l'une des revendications précédentes,
dans lequel une maintenance prédictive de la machine (10) est effectuée sur la base d'au moins un paramètre mécanique (30).

15. Machine industrielle (10) comprenant un mécanisme qui comprend un moteur (12) et au moins deux autres composants (K1, K2, K3), les composants (K1, K2, K3) étant couplés les uns aux autres, au moins les deux composants (K1, K2, K3) se déplaçant différemment lorsque le moteur (12) entraîne le mécanisme, la machine (10) comprenant moins un capteur et un dispositif de calcul (25) et étant configurée pour

- déterminer de manière répétée au moins une grandeur de mouvement (W1-W9) de l'un des composants (K1, K2, K3) du mécanisme,
- déterminer de manière répétée au moins une grandeur dynamique (32) de l'un des composants (K1, K2, K3) du mécanisme,
- calculer, au moyen d'un modèle du mécanisme, les grandeurs de mouvement (W1-W9) des autres composants (K1, K2, K3) du mécanisme,
- définir des paramètres mécaniques séparés (30) pour les composants (K1, K2, K3) du mécanisme à partir de la grandeur de mouvement (W1-W9) déterminée, de la grandeur dynamique déterminée et des grandeurs de mouvement (W1-W9) calculées,

**caractérisée en ce que**

la machine (10) est conçue pour calculer les paramètres mécaniques (30) par un système d'équations matriciel de la forme

$$A * (MP) = (M)$$

**A** étant représenté par

$$
\begin{pmatrix}
\alpha_{K1,t1} & \omega_{K1,t1} & 1 & acc_{K2,t1} * \frac{dx_{K2,t1}}{d\varphi_{K1,t1}} & vel_{K2,t1} * \frac{dx_{K2,t1}}{d\varphi_{K1,t1}} & \frac{dx_{K2,t1}}{d\varphi_{K1,t1}} & \alpha_{K3,t1} * \frac{d\varphi_{K3,t1}}{d\varphi_{K1,t1}} & \omega_{K3,t1} * \frac{d\varphi_{K3,t1}}{d\varphi_{K1,t1}} & \frac{d\varphi_{K3,t1}}{d\varphi_{K1,t1}} \\
\alpha_{K1,t2} & \omega_{K1,t2} & 1 & acc_{K2,t2} * \frac{dx_{K2,t2}}{d\varphi_{K1,t2}} & vel_{K2,t2} * \frac{dx_{K2,t2}}{d\varphi_{K1,t2}} & \frac{dx_{K2,t2}}{d\varphi_{K1,t2}} & \alpha_{K3,t2} * \frac{d\varphi_{K3,t2}}{d\varphi_{K1,t2}} & \omega_{K3,t2} * \frac{d\varphi_{K3,t2}}{d\varphi_{K1,t2}} & \frac{d\varphi_{K3,t2}}{d\varphi_{K1,t2}} \\
\dots & \dots & \dots & \dots & & \dots & \dots & \dots & \dots \\
\alpha_{K1,tn} & \omega_{K1,tn} & 1 & acc_{K2,tn} * \frac{dx_{K2,tn}}{d\varphi_{K1,tn}} & vel_{K2,tn} * \frac{dx_{K2,tn}}{d\varphi_{K1,tn}} & \frac{dx_{K2,tn}}{d\varphi_{K1,tn}} & \alpha_{K3,tn} * \frac{d\varphi_{K3,tn}}{d\varphi_{K1,tn}} & \omega_{K3,tn} * \frac{d\varphi_{K3,tn}}{d\varphi_{K1,tn}} & \frac{d\varphi_{K3,tn}}{d\varphi_{K1,tn}}
\end{pmatrix}
$$

$$\begin{pmatrix} J_{K1} \\ k_{Mvel,K1} \\ k_{Mstat,K1} \\ m_{K2} \\ k_{Fvel,K2} \\ k_{Fstat,K2} \\ J_{K3} \\ k_{Mvel,K3} \\ k_{Mstat,K3} \end{pmatrix}$$

(MP) étant représenté par                    et

$$\begin{pmatrix} M_{t1} \\ M_{t2} \\ ... \\ M_{tn} \end{pmatrix}$$

(M) étant représenté par

**A** étant une matrice des grandeurs de mouvement (W1-W9), (MP) étant un vecteur avec les paramètres mécaniques (30) à déterminer, et (M) étant un vecteur des grandeurs dynamiques (32), le vecteur comprenant des couples de rotation qui correspondent chacun au couple de rotation fourni par le moteur (12) à un certain instant,

et

a étant une accélération angulaire,

J étant un couple d'inertie,

ω étant une vitesse angulaire,

k étant un paramètre,

dx/dφ et dφ/dφ étant des dérivées de fonctions de transfert,

acc étant une accélération, et

vel étant une vitesse.

Fig. 1

28  26

34  36  38  34  30  32

$$
\begin{pmatrix}
\alpha_{K1,t1} & \omega_{K1,t1} & 1 \\
\alpha_{K1,t2} & \omega_{K1,t2} & 1 \\
... & ... & ... \\
\alpha_{K1,tn} & \omega_{K1,tn} & 1
\end{pmatrix}
\begin{matrix}
acc_{K2,t1} * \frac{dx_{K2,t1}}{d\varphi_{K1,t1}} & vel_{K2,t1} * \frac{dx_{K2,t1}}{d\varphi_{K1,t1}} & \frac{dx_{K2,t1}}{d\varphi_{K1,t1}} \\
acc_{K2,t2} * \frac{dx_{K2,t2}}{d\varphi_{K1,t2}} & vel_{K2,t2} * \frac{dx_{K2,t2}}{d\varphi_{K1,t2}} & \frac{dx_{K2,t2}}{d\varphi_{K1,t2}} \\
... & ... & ... \\
acc_{K2,tn} * \frac{dx_{K2,tn}}{d\varphi_{K1,tn}} & vel_{K2,tn} * \frac{dx_{K2,tn}}{d\varphi_{K1,tn}} & \frac{dx_{K2,tn}}{d\varphi_{K1,tn}}
\end{matrix}
\begin{matrix}
acc_{K3,t1} * \frac{dx_{K3,t1}}{d\varphi_{K1,t1}} & vel_{K3,t1} * \frac{dx_{K3,t1}}{d\varphi_{K1,t1}} & \frac{dx_{K3,t1}}{d\varphi_{K1,t1}} \\
acc_{K3,t2} * \frac{dx_{K3,t2}}{d\varphi_{K1,t2}} & vel_{K3,t2} * \frac{dx_{K3,t2}}{d\varphi_{K1,t2}} & \frac{dx_{K3,t2}}{d\varphi_{K1,t2}} \\
... & ... & ... \\
acc_{K3,tn} * \frac{dx_{K3,tn}}{d\varphi_{K1,tn}} & vel_{K3,tn} * \frac{dx_{K3,tn}}{d\varphi_{K1,tn}} & \frac{dx_{K3,tn}}{d\varphi_{K1,tn}}
\end{matrix}
*
\begin{pmatrix}
J_{K1} \\
k_{Mvel,K1} \\
k_{Mstat,K1} \\
m_{K2} \\
k_{Fvel,K2} \\
k_{Fstat,K2} \\
m_{K3} \\
k_{Fvel,K3} \\
k_{Fstat,K3}
\end{pmatrix}
=
\begin{pmatrix}
M_{t1} \\
M_{t2} \\
... \\
M_{tn}
\end{pmatrix}
$$

W1  W2  W3  W4  W5  W6  W7  W8  W9  36  38

Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 3258331 A1
- DE 102015200609 A1
- DE 102011121839 A1